(19) **Europäisches Patentamt European Patent Office Office européen des brevets**

(11) **EP 4 553 517 A1**

(12) **EUROPEAN PATENT APPLICATION**
published in accordance with Art. 153(4) EPC

(43) Date of publication:
14.05.2025 Bulletin 2025/20

(21) Application number: 23835386.6

(22) Date of filing: 27.06.2023

(51) International Patent Classification (IPC):
$G01R\ 31/367^{(2019.01)}$     $G01R\ 31/378^{(2019.01)}$
$G01R\ 31/382^{(2019.01)}$     $G01R\ 31/385^{(2019.01)}$
$G01R\ 31/387^{(2019.01)}$     $G01R\ 31/389^{(2019.01)}$
$G01R\ 31/392^{(2019.01)}$     $H01M\ 10/44^{(2006.01)}$
$H01M\ 10/48^{(2006.01)}$      $H02J\ 7/00^{(2006.01)}$

(52) Cooperative Patent Classification (CPC):
G01R 31/367; G01R 31/378; G01R 31/382;
G01R 31/385; G01R 31/387; G01R 31/389;
G01R 31/392; H01M 10/44; H01M 10/48;
H02J 7/00; Y02E 60/10

(86) International application number:
PCT/JP2023/023864

(87) International publication number:
WO 2024/009854 (11.01.2024 Gazette 2024/02)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
KH MA MD TN

(30) Priority: 07.07.2022 JP 2022110054

(71) Applicant: Daiwa Can Company
Chiyoda-ku, Tokyo 100-7009 (JP)

(72) Inventors:
• ARIMA, Masahito
  Sagamihara-shi, Kanagawa 252-5183 (JP)
• LIN, Lei
  Sagamihara-shi, Kanagawa 252-5183 (JP)
• ONIKI, Naoki
  Sagamihara-shi, Kanagawa 252-5183 (JP)

(74) Representative: AWA Sweden AB
Matrosgatan 1
Box 5117
200 71 Malmö (SE)

(54) **ECONOMIC FEASIBILITY ESTIMATION DEVICE AND ECONOMIC FEASIBILITY ESTIMATION METHOD USING CHARGE AND DISCHARGE CURVE OF BATTERY**

(57) An economic efficiency estimation apparatus derives an approximate curve of an initial open-end voltage function and an initial impedance function, sets a prior estimation function, and measures a charge-discharge voltage and a charge-discharge current. A state estimation unit estimates state parameters including an SOC value, and a polarization voltage and an internal impedance using a Kalman filter. The apparatus obtains an estimation error between a prior estimation voltage and an actually measured voltage, calculates a posterior estimation value by a correction expression using a Gaussian function having a learning rate and a correction width as terms which are set for the estimation error and current value, corrects the prior estimation function based on the posterior estimation value, sets a new prior estimation function, estimates a charge-discharge curve, and estimates an economic efficiency index based on a charge-discharge power amount of the secondary battery estimated from the curve.

F I G. 1

EP 4 553 517 A1

## Description

FIELD

Embodiments of the present invention relate to an economic efficiency estimation apparatus and an economic efficiency estimation method for achieving economic efficiency and efficiency degradation using an estimated charge-discharge curve of a rechargeable battery.

BACKGROUND

In recent years, variable renewable energy such as solar power generation and wind energy has increased. Due to this increase in energy, various methods have been proposed to use an excess power amount accompanying a change in power demand. The rechargeable battery capable of repeatedly performing charging and discharging, for example, a lithium ion battery is a candidate for using the excess power amount.

The lithium ion battery can be used for the purpose of peak cut of power demand, peak shift to be used in daytime by storing nighttime power, or as an emergency power supply for disaster countermeasures by charging the excess power amount. It has been studied to obtain an economic merit by optimizing power use at the time of application of time-of-use charges by utilizing such a lithium ion battery.

In addition, the lithium ion battery to be used includes not only an unused product but also a product that is reused after being used as a drive source of various devices. Therefore, it is important to grasp a degradation state of the lithium ion battery.

SUMMARY

(Technical Problem)

When a plurality of the lithium ion batteries described above is used as an aggregate, it is necessary not only to grasp the degradation state of each lithium ion battery but also to consider charge-discharge efficiency characteristics. Various lithium ion batteries used as the aggregate have various types, manufacturers, and reuse histories, and also have various charge-discharge efficiency characteristics. Naturally, operating highly efficient lithium ion batteries results in less energy loss and higher economic benefits. That is, in order to use the plurality of lithium ion batteries as the aggregate, it is necessary to perform not only capacity degradation diagnosis but also efficiency degradation diagnosis.

This efficiency degradation diagnosis requires estimating charge-discharge cycle energy efficiency defined as a ratio of discharge energy to charge energy. This charge-discharge energy can be obtained by a full charge capacity (FCC), an open circuit voltage (OCV), an internal impedance (Z), and a charging rate (SOC). Therefore, in order to obtain the charge-discharge energy, a function of an OCV value and a Z value with respect to an SOC value is required.

A method for estimating the OCV value is roughly divided into two groups. A first group is a method using a pseudo OCV (hereinafter referred to as pOCV). In a pOCV measurement process, the lithium ion battery is generally charged and discharged once at a constant current of 10 hour rate (c/10) or less in a range from complete discharge to full charge, and the OCV value is calculated as an average value of charge-discharge voltages. A second group is a galvanostatic intermittent titration technique (GITT). The GITT is a method of charging and discharging a square wave current with long-time relaxation between waves. Further, estimation of the Z value can be calculated by dividing a difference between the charge-discharge voltage and the OCV value by the current. That is, the Z value can be estimated along with a pOCV value or a GITT process.

However, conditions for applying the pOCV value and the GITT include a very long constant current period, and are significantly different from a form in which the plurality of lithium ion batteries are used as the aggregate, and thus are not suitable as a method for estimating the OCV value during operation.

Accordingly, an object of the present invention is to provide an economic efficiency estimation apparatus and an economic efficiency estimation method for estimating economic efficiency and efficiency degradation of various rechargeable batteries including a reused battery, and an aggregate of a plurality of rechargeable batteries by using the charge-discharge curve of the rechargeable battery.

(Solution of Problem)

According to an embodiment of the present invention, to achieve the object, there is provided an economic efficiency estimation apparatus using a charge-discharge curve, comprising: a function derivation unit configured to derive an approximate curve of an open-end voltage function and an impedance function to be corrected a first time, and set the approximate curve as a prior estimation function; a charge unit configured to detect a charge state of a secondary battery and charge the secondary battery within a range up to a predetermined charge upper limit voltage; a discharge unit configured to electrically connect a load to the secondary battery and cause the secondary battery to discharge power; a measurement unit configured to measure a charge-discharge voltage and a charge-discharge current in a cycle of a predetermined time from a start of charging or discharging by the charge unit or the discharge unit; a state estimation unit configured to estimate state parameters including a value of a charging rate, and a polarization voltage and an internal impedance of the secondary battery using an algorithm of a Kalman filter; and an estimation arithmetic processing unit configured to obtain an estimation error of an open-end voltage value and an impedance value from the prior estimation function, the state parameters, and a relational expression of the charge-discharge voltage and the charge-discharge current measured by the measurement unit, calculate a posterior estimation value by correcting the open-end voltage value and the impedance value in accordance with a correction expression using a Gaussian function having a predetermined learning rate L and a correction width $\sigma$ as terms, correct the prior estimation function based on the posterior estimation value, set a new prior estimation function, estimate the charge-discharge curve, wherein an economic efficiency index is estimated based on a charge-discharge power amount of the secondary battery estimated from the charge-discharge curve.

Further, according to an embodiment of the present invention, to achieve the object, there is provided an economic efficiency estimation method, comprising: deriving an approximate curve of an open-end voltage function and impedance function to be corrected a first time, and setting the approximate curve as a prior estimation function; detecting a charge state of a secondary battery and charging the secondary battery within a range up to a predetermined charge upper limit voltage; discharging power from the secondary battery by a load connected to the secondary battery; measuring a charge-discharge voltage and a charge-discharge current in a cycle of a predetermined time from a start of charging or discharging; estimating state parameters including a value of a charging rate, and a polarization voltage and an internal impedance of the secondary battery using an algorithm of a Kalman filter; obtaining an estimation error of an open-end voltage value and an impedance value from the prior estimation function, the state parameters, and a relational expression of the charge-discharge voltage and the charge-discharge current measured by the measurement unit, calculating a posterior estimation value by correcting the open-end voltage value and the impedance value in accordance with a correction expression using a Gaussian function having a predetermined learning rate L and a correction width $\sigma$ as terms, correcting the prior estimation function based on the posterior estimation value, setting a new prior estimation function, and estimating a charge-discharge curve; and estimating charge-discharge energy per cycle using the open-end voltage estimation function and the impedance estimation function according to the following equation, and estimating economic efficiency using the charge-discharge energy and an electricity rate for each time zone

$$\widehat{W}_{c,d} = C_{fc} \int_0^1 \left\{ \hat{V}_{oc}(S_{oc}) + \hat{I}_{c,d}(S_{oc}) \cdot \hat{R}(S_{oc}) \right\} dS_{oc}$$

where, $C_{fc}$ is a value of a full charge capacity corresponding to each cycle, $\widehat{W}_{c,d}$ is an estimated value of estimated charge-discharge energy, $\hat{V}_{oc}(S_{oc})$ is an open-end voltage estimation function, $\hat{Z}(S_{oc})$ is an impedance estimation function, and $\hat{I}_{c,d}(S_{oc})$ is the charge-discharge current.

(Advantageous Effects)

According to the present invention, it is possible to provide an economic efficiency estimation apparatus and an economic efficiency estimation method for estimating economic efficiency and efficiency degradation applicable to various rechargeable batteries and the aggregate of the plurality of rechargeable batteries using the charge-discharge curve of the rechargeable battery.

BRIEF DESCRIPTION OF THE DRAWINGS

FIG. 1 is a block diagram illustrating a configuration of a power storage apparatus including a charge-discharge curve and economic efficiency estimation apparatus of a rechargeable battery according to an embodiment.
FIG. 2 is a block diagram illustrating a configuration example of the charge-discharge curve and economic efficiency estimation apparatus of the rechargeable battery.
FIG. 3 is a diagram illustrating specifications of an example of a lithium ion battery.
FIG. 4 is a diagram conceptually illustrating a corrected approximate curve of an open circuit voltage OCV.
FIG. 5 is a diagram conceptually illustrating an equivalent circuit of the lithium ion battery.
FIG. 6 is a diagram illustrating a relationship between a condition combination of a learning rate L and a correction

width $\sigma$ and an error index.

FIG. 7 classifies a graph deformation rate (a magnitude of the learning rate) into three rough groups: "fast (high rate)", "middle (medium rate)", and "slow (low rate)".

FIG. 8A is a diagram illustrating characteristics by a process of increasing or decreasing a reference value in a direction in an image of a reference value of an initial $V^{\wedge}$ (Soc).

FIG. 8B is a diagram illustrating characteristics by a process of rotating the reference value around an Soc in the image of the reference value of the initial $V^{\wedge}$ (Soc).

FIG. 9A is a diagram illustrating an error index $I_{maer}$ corresponding to an adjustment coefficient of a group having a high deformation rate.

FIG. 9B is a diagram illustrating the error index $I_{maer}$ corresponding to an adjustment coefficient of a group having a medium deformation rate.

FIG. 9C is a diagram illustrating the error index $I_{maer}$ corresponding to an adjustment coefficient of a group having a low deformation rate.

FIG. 10A is a diagram illustrating a charge-discharge energy estimation value when a first adjustment coefficient is set.

FIG. 10B is a diagram illustrating the charge-discharge energy estimation value when a second adjustment coefficient is set.

FIG. 10C is a diagram illustrating the charge-discharge energy estimation value when a third adjustment coefficient is set.

FIG. 10D is a diagram illustrating the charge-discharge energy estimation value when a fourth adjustment coefficient is set.

FIG. 10E is a diagram illustrating the charge-discharge energy estimation value when a fifth adjustment coefficient is set.

FIG. 11 is a flowchart for describing a method for estimating a charge-discharge curve and economic efficiency of the rechargeable battery.

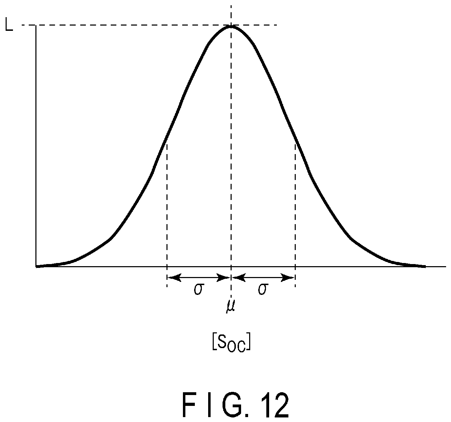

FIG. 12 is a diagram illustrating a Gaussian function.

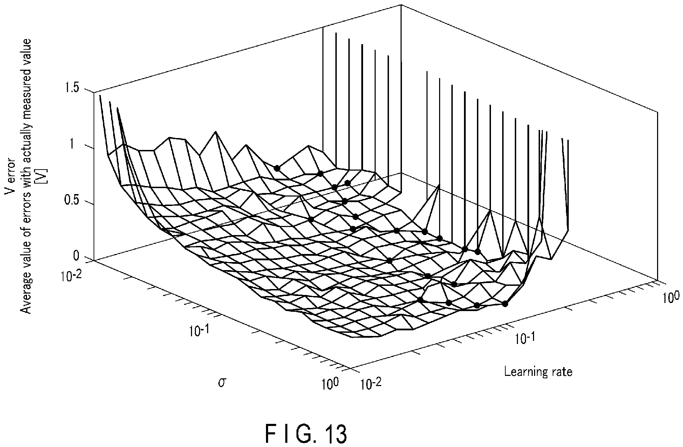

FIG. 13 is a diagram illustrating an average error of a charge-discharge curve estimation result of the present embodiment.

FIG. 14 is a diagram for describing an economic merit estimated from a differential voltage of each cycle.

## EMBODIMENTS

Hereinafter, an economic efficiency estimation apparatus and an economic efficiency estimation method for a rechargeable battery according to an embodiment of the present invention will be described with reference to the drawings.

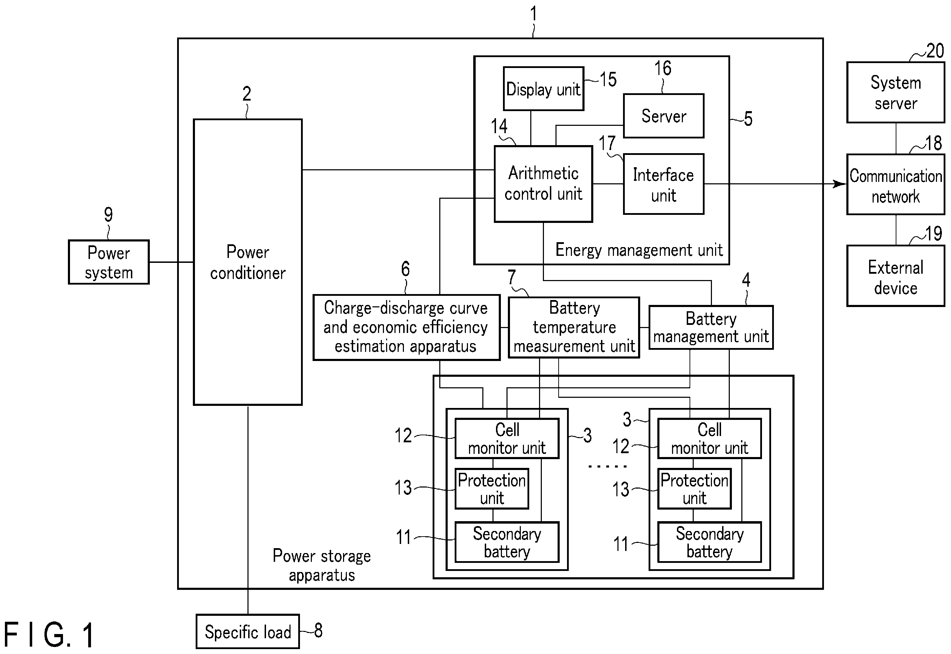

FIG. 1 illustrates a configuration of a power storage apparatus including the economic efficiency estimation apparatus for the rechargeable battery according to the present embodiment. This power storage apparatus 1 mainly includes a power conditioner (power conditioning system) 2, a battery module 3, a battery management unit (BMU) 4, an energy management unit (EMU) or energy management system (EMS) 5, a charge-discharge curve and economic efficiency estimation apparatus 6, and a battery temperature measurement unit 7. Note that although not illustrated in the drawings, component parts included in an ordinary power storage apparatus are assumed to be also included in the power storage apparatus of the present embodiment, and a detailed description thereof is omitted.

The power conditioner 2 functions as a so-called converter which converts power supplied from a power system 9 of an external electric power company or the like, power supplied from a solar power generation system, or power supplied from the battery module 3 to power which can be utilized by an electric drive device including a specific load 8. Furthermore, the power conditioner 2 may have a function of a charger which charges the rechargeable battery. For example, when the specific load 8 is an electric device driven by AC power, DC power supplied from the battery module 3 is converted to a power form of AC power. In addition, depending on the electric device of the specific load 8, the voltage value of power may be increased. Furthermore, the power conditioner 2 can not only supply power to the specific load 8 but also releases energy accumulated in the battery module 3 to reduce consumption of power supplied from the power system 9, when the consumption of power supplied from the power system 9 is maximum. In this case, when a power demand lowers, for example, in the middle of the night, the battery module 3 after discharge can be fully charged through the power conditioner 2.

The specific load 8 to which the power is supplied by the power storage apparatus 1 is assumed to be a device to which the power is to be supplied when power supply from the power system 9 is stopped (for example, at the time of power outage), and is for example, an electronic device such as a computer, or a communication device, and power supply for power supply backup is performed for the specific load 8.

The battery module 3 includes a secondary battery (rechargeable battery) 11 which outputs a DC voltage, a cell monitor unit (CMU) 12, and a protection unit 13. The number of battery modules 3 is appropriately set according to the design relating to an amount of power supplied to a specific load or the like, and when a large-capacity secondary battery is formed, a plurality of battery modules 3 may be electrically connected to form an aggregate, that is, a battery pack. Further, in the present embodiment, a lithium ion battery is described as an example of the secondary battery 11 for which charge-discharge curve estimation is performed, however, the embodiment is not limited to this. The present embodiment can be easily applied to a battery with a different configuration as long as the battery has a low memory effect and good self-discharge characteristics, like the lithium ion battery. For example, the present embodiment can also be applied to a nanowire battery or the like, which is an improvement of the lithium ion battery.

The secondary battery 11 of the present embodiment is not limited with respect to not only an inner battery material (for example, an electrode material) or a cell structure, but also a form of an exterior material, and may be a cylindrical canister type, a rectangular canister type, and a laminate type. Regarding a connection mode of the secondary battery 11 constituting the battery module 3, a publicly known connection mode, such as a single battery mode, a serial coupled battery mode, or a parallel coupled battery mode is applicable.

The battery temperature measurement unit 7 measures the temperature with a temperature sensor (not illustrated) disposed in contact with each of the secondary batteries 11. An ambient temperature, at which the lithium-ion battery can be used, in the apparatus is in a range of about 5°C to 40°C; however, if necessary, a battery temperature adjustment mechanism can be provided in the apparatus, depending on an environment of installation (cold region or tropical region). The battery temperature adjustment mechanism includes a fan and a heater for performing temperature adjustment within in a range (about 5°C to 40°C) in which the above-described secondary battery 11 is usable so that battery performance is not lowered when an upper limit or a lower limit of a preset temperature range is exceeded based on a temperature measured by the battery temperature measurement unit 7. Needless to say, when the temperature range in which the secondary battery 11 is usable increases due to future battery improvement, the temperature adjustment mechanism can adapt to the entire temperature range.

The cell monitor unit 12 continuously measures an output voltage, a current, and a temperature of each of the secondary batteries 11 of a single battery (or a single cell), and transmits a measurement result to the battery management unit 4. In particular, the cell monitor unit 12 measures a charge-discharge voltage every prescribed period of time during charge-discharge processing for charge-discharge curve estimation, in accordance with control of an arithmetic control unit 14 to be described later.

Furthermore, the cell monitor unit 12 transmits the output voltage, the current and the temperature acquired from the secondary battery 11 to the battery management unit 4 as monitor information. Based on the received monitor information, the battery management unit 4 determines occurrence of abnormality such as over-charge, over-discharge, and temperature rise, controls the protection unit 13, and stops charge or output (discharge) for the secondary batteries 11, thereby preventing over-charge and over-discharge. Note that when urgent abnormality occurs due to a fault or the like of the secondary battery 11, the protection unit 13 stops charge or output (discharge) for the secondary battery 11 by electrical shutoff.

Furthermore, the protection unit 13 may be provided with a function of avoiding risk by notifying the battery management unit 4 of the abnormality. Note that it is essential to determine the occurrence of the abnormality. The determination function may be provided in either the cell monitor unit 12 on the battery module 3 side or the battery management unit 4 on the power storage apparatus 1 side, or may be provided in both to improve safety by double determination. In the double determination, the order of determination is determined in advance, and for example, the cell monitor unit 12 first determines the occurrence of the abnormality and then the battery management unit 4 determines the occurrence of the abnormality a second time. As a determination procedure at this time, the protection unit 13 executes a protection operation when one of two determination units determines that the abnormality has occurred. Note that, although depending on the design concept, it is also possible to perform the protection operation by the protection unit 13 only when both of the determination units determine that the abnormality has occurred, and issue a warning when only one of them determines that the abnormality has occurred.

Furthermore, the battery management unit 4 centrally aggregates monitor information transmitted from the cell monitor units 12 of the battery modules 3, and transmits the monitor information to the energy management unit 5 at an upper level. Based on the monitor information, the energy management unit 5 instructs the power conditioner 2 to charge and discharge the battery module 3. In accordance with the instruction, the power conditioner 2 controls charging and discharging of the battery module 3.

The energy management unit 5 includes the arithmetic control unit 14, a display unit 15, a server 16, and an interface unit 17.

The arithmetic control unit 14 has a function equivalent to that of an arithmetic processing unit or the like of the computer, and instructs the battery management unit 4 or the power conditioner 2 to charge and discharge the battery module 3. In addition, a charge upper limit voltage value and a discharge lower limit voltage value are preset for each of the battery modules 3, and the arithmetic control unit 14 provides an instruction to stop charging or stop discharging to the battery management unit 4 or the power conditioner 2 based on the monitor information transmitted from the battery management unit 4.

The display unit 15 includes, for example, a liquid crystal display unit, and displays an operation state of the power storage apparatus 1, a remaining capacity or the like of the battery module 3 (secondary battery 11), and warning matters under the control of the arithmetic control unit 14. Further, the display unit 15 may employ a touch panel or the like to be used as an input device.

The server 16 stores as needed in an accumulating manner the latest information on the operation state of the power storage apparatus 1, the monitor information relating to the battery modules 3 or the like, information relating to a charge-discharge curve, and the like, which have been transmitted to the energy management unit 5. The interface unit 17 communicates with a centralized management system including the server or the like installed outside through a communication network 18 such as the Internet.

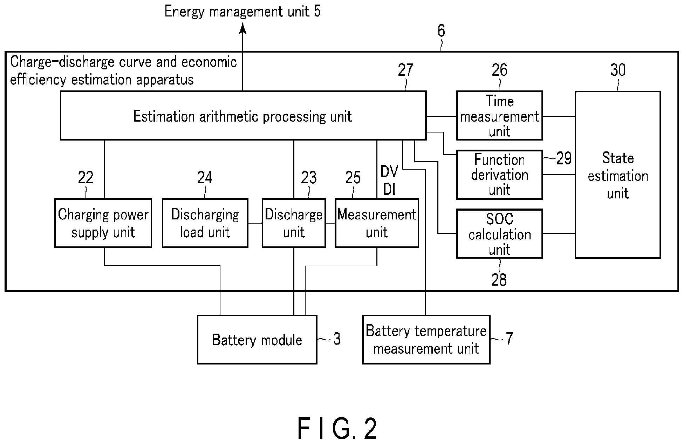

Next, the charge-discharge curve and economic efficiency estimation apparatus 6 of the rechargeable battery will be described. FIG. 2 illustrates a configuration example of the charge-discharge curve and economic efficiency estimation apparatus 6 of the rechargeable battery.

The charge-discharge curve and economic efficiency estimation apparatus 6 includes a charging power supply unit 22, a discharge unit 23, a discharging load unit 24, a measurement unit 25, a time measurement unit 26, an estimation arithmetic processing unit 27, an SOC calculation unit 28, a function derivation unit 29, and a state estimation unit 30. The estimated charge-discharge curve of each secondary battery 11 and an economic efficiency index SOEc are stored in the server 16.

The charging power supply unit 22 detects a charge state of the secondary battery 11, and outputs a rated DC voltage to the secondary battery 11 within a range up to a charge upper limit voltage of the secondary battery 11 to charge the secondary battery 11.

The charging power supply unit 22 is provided as a dedicated power supply for estimating the charge-discharge curve and the economic efficiency index SOEc of the secondary battery 11, however, a battery charging power supply unit usually provided in the power storage apparatus or the power conditioner 2 may be used. In the present embodiment, the measurement unit 25 and the charging power supply unit 22 constitute a charge unit. Further, in the following description, estimation of the economic efficiency index SOEc and economic efficiency estimation have the same meaning.

The discharge unit 23 includes the discharging load unit 24, electrically connects the secondary battery 11 and the discharging load unit 24 by a switch operation (not illustrated), and causes the secondary battery 11 to discharge a predetermined amount of power (here, a constant current or a constant voltage is assumed). The discharging load unit 24 may be a resistor or an electronic load, but the load may be simulated and regenerated in the power system without providing such an exclusive load.

The measurement unit 25 measures a DC voltage and a DC current output from the battery module 3 (secondary battery 11). As the measurement timing, the DC voltage and the DC current output from the battery module 3 are periodically measured every time a predetermined certain time elapses. Note that as voltage and current measurements, instead of actually measuring the voltage and current, it is also possible to use the voltage value and current value included in the latest monitor information transmitted from the battery management unit 4 and stored in the server 16 of the energy management unit 5.

The time measurement unit 26 is a timer for measuring a time during which power is discharged from the battery module 3, and measures the measurement timing.

The SOC calculation unit 28 calculates a charging rate (state of charge (SOC)) at a timing when the measurement unit 25 measures the voltage. The SOC value is a value obtained by dividing a charge current amount Qc [Ah] by a full charge capacity FCC [Ah] at that time. An SOC value of the charging rate of the present embodiment is calculated using a Kalman filter described later. Note that the full charge capacity FCC value can be calculated by an appropriate method such as a charge-discharge differential voltage method, an AC impedance method, a discharge curve differentiation method, or optimization filtering. For example, it may be calculated by dividing a difference between accumulated charge amounts at two time points by a difference between the SOCs estimated by the Kalman filter.

The function derivation unit 29 derives an approximate curve of an open circuit voltage function and an impedance function to be corrected, and sets the approximate curve as a prior estimation function. Various curve fitting methods can be applied to obtain the approximate curve, and the approximate curve obtained in advance can be stored and set as the prior estimation function. Further, an initial open circuit voltage function and an initial prior estimation function can also be derived.

The estimation arithmetic processing unit 27 is an arithmetic processing unit (such as a CPU) that stores an arithmetic algorithm using a relational expression to be described later, and estimates each of the charge-discharge curve and the economic efficiency (economic efficiency index SOEc) based on machine learning and estimated state parameters of the secondary battery 11. The estimation arithmetic processing unit 27 is not necessarily dedicatedly provided in the charge-discharge curve and economic efficiency estimation apparatus 6 of the secondary battery, and can cause the arithmetic control unit 14 of the energy management unit 5 to substitute a processing function.

The state estimation unit 30 estimates state parameters including the charging rate SOC, an open circuit voltage OCV, and an internal impedance Z in the secondary battery 11 using a Kalman filter based on an electrochemical model, in the present embodiment, an extended Kalman filter that supports nonlinearity.

In the present embodiment, an online estimation method using network communication can be applied to an external device 19, a system server 20 that manages other power storage apparatuses 1, and the like through the communication network 18 such as the Internet. Note that in FIG. 1, a power storage apparatus 1 is representatively illustrated for easy understanding of the description, and the power storage apparatus 1 is not limited to one.

[Kalman filter]

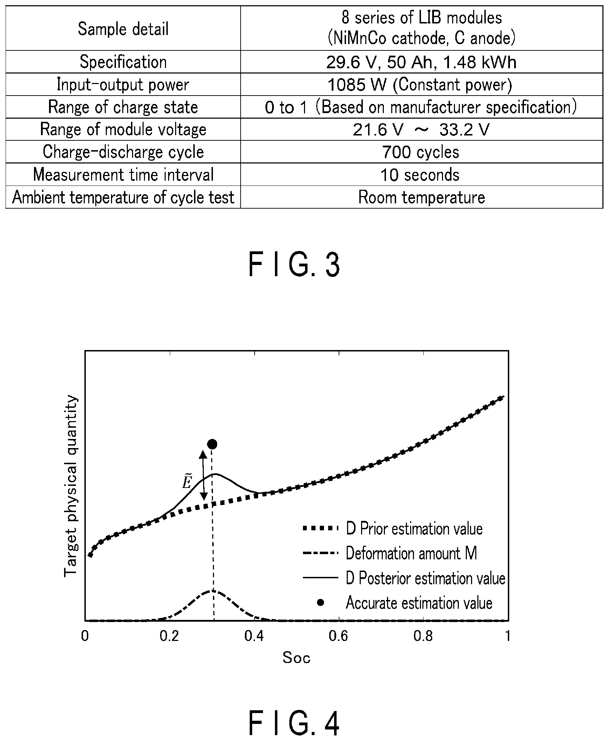

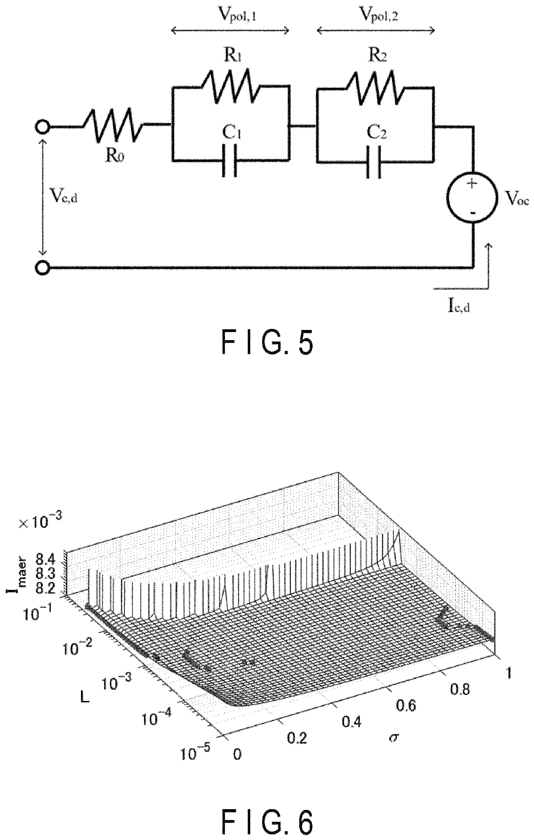

Hereinafter, estimation of the charge-discharge curve used for degradation diagnosis and economic efficiency estimation in a charge-discharge cycle of the lithium ion battery using the Kalman filter of the state estimation unit 30 and a Gaussian function will be described. FIG. 3 is a diagram illustrating specifications of an example of the lithium ion battery. FIG. 4 is a diagram conceptually illustrating a corrected approximate curve of the open circuit voltage OCV. FIG. 5 is a diagram conceptually illustrating an equivalent circuit of the lithium ion battery.

In the present embodiment, as an example, eight series of lithium ion battery modules connected in series are charged and discharged to acquire time-series data thereof. Note that in the case of performing degradation diagnosis and state estimation, a cycle test using a single battery of a small lithium ion battery is generally adopted, but in the present embodiment, it is also possible to regard a lithium ion battery module including a large single battery of 50Ah as a battery pack (aggregate) and perform the degradation diagnosis and state estimation. Further, during a charge-discharge cycle test, a constant power mode is employed to simulate a situation of charging and discharging by the power conditioner 2. An ambient temperature in the cycle test is preferably room temperature, but since unavoidable resistance heat generation occurs during charging and discharging, a module temperature is set to a range of about 20°C to 30°C.

Graph deformation of the open circuit voltage OCV and the internal impedance Z in the lithium ion battery illustrated in FIG. 4 was performed by addition of a Gaussian function with adjusted height. That is, a value obtained by multiplying an error (estimation error) between a prior estimation value (scalar) at the point of a current charging rate SOC and a posterior estimation value (scalar) currently estimated by the Kalman filter by the learning rate L is set as the height of the Gaussian function, and added to a prior estimation value (vector) of graph learning. A function of a graph deformed in this way is a posterior estimation value (vector) of graph learning.

Next, an error index $I_{maer}$ is defined as an average absolute error rate by the following equation (2).

$$I_{maer} = \frac{1}{700} \sum_{i=1}^{700} \left| \frac{\widetilde{W}_{c,d,i}}{W_{c,d,i}} \right| \qquad (2)$$

Here, since a combination condition of the learning rate L and a rough range of the correction width $\sigma$ affects an accuracy of charge-discharge energy estimation, a relationship between these conditions and an index of the estimation error was analyzed. In this analysis, an actual initial Voc(Soc) is adopted as a reference for $C_k$ of the Kalman filter at a start of a first cycle. This result is as shown in FIG. 6. FIG. 6 is a diagram illustrating a relationship between a condition combination of the learning rate L and a rough correction width $\sigma$ and an error index $I_{maer}$. Each of dots is a point of best accuracy in an entire learning rate L.

From the result illustrated in FIG. 6, an estimation process diverges in most cases when the learning rate L satisfies $L > 10^{-2}$, and converges when the correction width $\sigma$ is reduced.

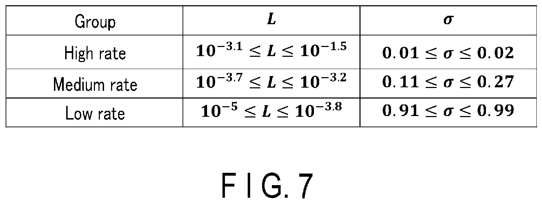

This is because the learning rate L and the correction width $\sigma$ having large values are affected by an input of E-for excessive graph deformation. In addition, in a tendency of an optimum correction width $\sigma$, the learning rate L changes at boundaries of $L=10^{-3.8}$ and $L=10^{-3.2}$. Here, a condition combination of the learning rate L and the correction width $\sigma$ is classified into three rough groups in which a graph deformation rate (magnitude of the learning rate L or learning speed) illustrated in FIG. 7 is different, that is, "fast (high rate)", "middle (medium rate)", and "slow (low rate)". A relationship between the magnitude of the learning rate L and the deformation rate is such that, the deformation rate increases as the learning rate L increases, and the deformation rate decreases as the learning rate L decreases.

In addition, when the graph deformation by Gaussian function addition and the Kalman filter are used together, the learning rate L is set to a value close to 1 to simply combine them, however, in this setting, learning diverges, and appropriate charge-discharge energy estimation cannot be performed. Therefore, in the present embodiment, divergence can be prevented by adjusting the learning rate L to "0.1 or less" and also adjusting the correction width $\sigma$. Furthermore, more preferably, by adopting the learning rate L and the correction width $\sigma$ such that the relationship between the learning rate L and the correction width $\sigma$ satisfies the following equation (3), which is a correction expression using the Gaussian function,

$$L \leqq -10^{(-12.5\sigma - 1.375)}, \quad 0 < \sigma \leqq 0.11 \qquad (3)$$

high-speed and accurate profile learning can be performed.

Next, an error of OCV profile data was then artificially adopted and applied as an initial reference for the $C_k$ of the Kalman filter. This assumption implies an unclear initial open circuit voltage OCV which is a concern in the case of a reused lithium ion battery. When starting to use the reused battery, a current OCV value or possibly the electrode material used in the single battery may be known, but an overall open-end voltage estimation function V^oc(Soc) profile is unknown. Therefore, the open-end voltage estimation function V^oc(Soc) has to be estimated from limited lithium ion battery information.

In order to numerically deviate a reference value V^oc(Soc) of the initial open circuit voltage OCV from the actual initial Voc(Soc), the following two equations (4) and (5) are used.

$$\hat{V}_{oc}(S_{oc}) = K_{sep,1}V_{oc}(S_{oc}) \qquad\qquad (4)$$

$$\hat{V}_{oc}(S_{oc}) = \left(1 + K_{sep,2}\right)V_{oc}(S_{oc}) - K_{sep,2}V_{oc}(0.5) \qquad\qquad (5)$$

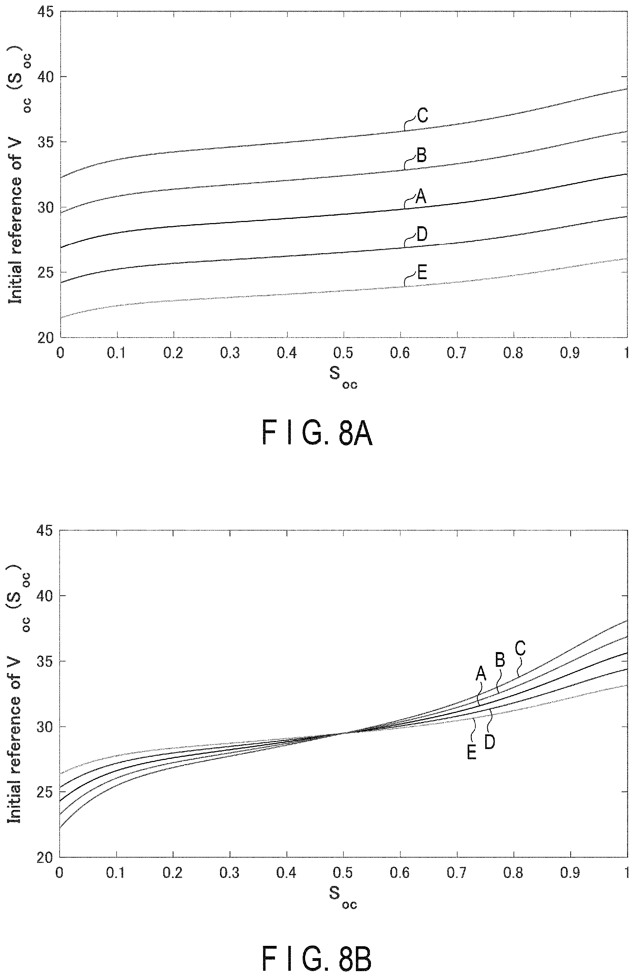

In the equations (4) and (5), $K_{sep,1}$ and $K_{sep,2}$ are adjustment coefficients. The equation (4) is a process of increasing ($K_{sep,1} > 1$) or decreasing ($K_{sep,1} < 1$) a value of V^oc(Soc) in a direction. On the other hand, the equation (5) is a process of rotating the reference value around Soc = 0.5. Images of the equations (4) and (5) are illustrated in FIGS. 8A and 8B.

FIG. 8A illustrates characteristics according to the equation (4) in an image of reference value of an initial V^oc(Soc) generated by $K_{sep,1}$ and $K_{sep,2}$, and FIG. 8B similarly illustrates characteristics according to the equation (5) in the image of the reference value of the initial V^oc(Soc) generated by $K_{sep,1}$ and $K_{sep,2}$.

In FIGS. 8A and 8B, a center line A in the figures is an actual V^oc(Soc), and other lines B, C, D, and E around the center line A are deformed and deviated by $K_{sep,1}$ and $K_{sep,2}$. Further, when these two equations are combined, they can be expressed as the following equation (6).

$$\hat{V}_{oc}(S_{oc}) = \left(K_{sep,1} + K_{sep,2}\right)V_{oc}(S_{oc}) - K_{sep,2}V_{oc}(0.5) \qquad\qquad (6)$$

Next, the charge-discharge energy estimation will be described.

For example, 700 cycles of the charge-discharge energy estimation were performed using various $K_{sep,1}$ and $K_{sep,2}$, a representative learning rate L and correction width $\sigma$ of the graph under each condition illustrated in FIG. 7. This analysis focuses on acceptability of OCV estimation error V-oc(Soc) generated in the equation (6).

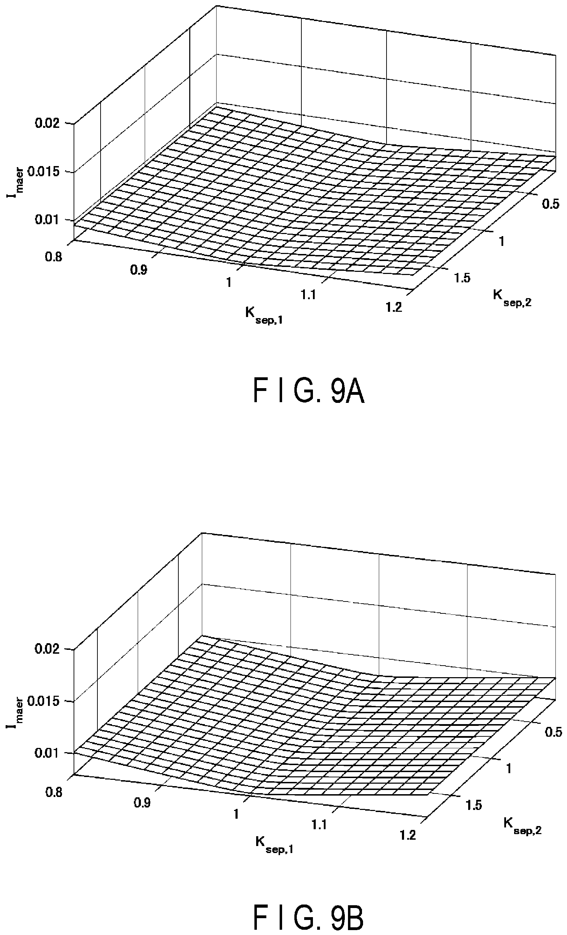

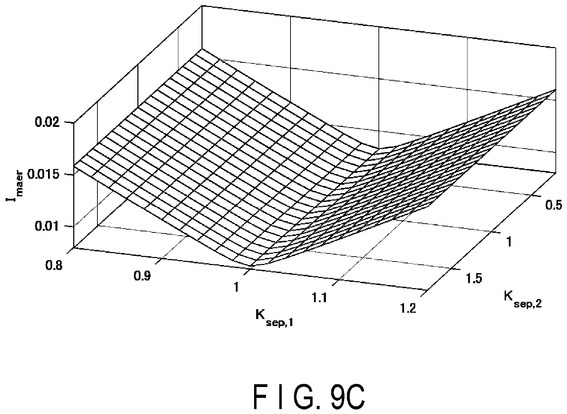

FIGS. 9A, 9B, and 9C illustrate error indexes $I_{maer}$ in the charge-discharge energy estimation corresponding to various values of $K_{sep,1}$ and $K_{sep,2}$. FIG. 9A illustrates the error index $I_{maer}$ corresponding to $K_{sep,1}$ and $K_{sep,2}$ of a group having a high deformation rate. FIG. 9B illustrates the error index $I_{maer}$ corresponding to $K_{sep,1}$ and $K_{sep,2}$ of a group having a middle (medium) deformation rate. FIG. 9C illustrates the error index $I_{maer}$ corresponding to $K_{sep,1}$ and $K_{sep,2}$ of a group having a low deformation rate.

According to FIGS. 9A, 9B, and 9C and the equation (6), $K_{sep,1}$ affected an average absolute error rate $I_{maer}$ of a charge-discharge energy estimation error, whereas $K_{sep,2}$ had less influence. Deviation of $K_{sep,1}$ from 1 led to a further increase in $I_{maer}$. The $I_{maer}$ tended to increase as the deformation rate decreased, that is, as the learning rate L decreased.

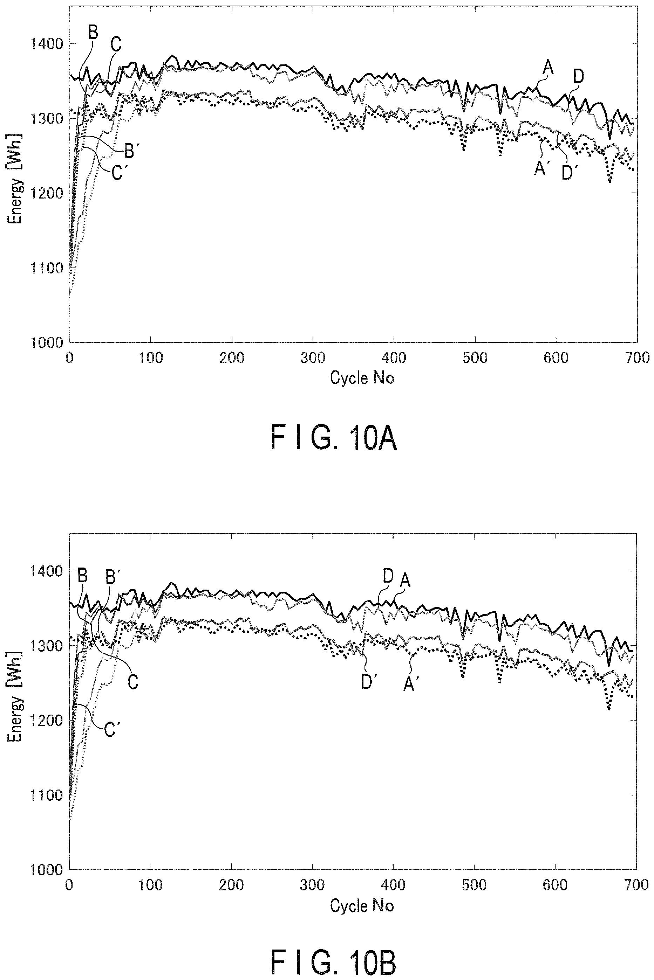

Next, based on these observation results, the charge-discharge energy estimation of each cycle is examined. This starts with any or uncertain initial OCV value generated from extreme $K_{sep,1}$ and $K_{sep,2}$. This optional OCV value was generated using the equation (6). In addition, any one of three graph deformation conditions illustrated in FIG. 7 was used. In this study, estimation started from a correct open circuit voltage OCV profile was added as a comparison object. The results are illustrated in FIGS. 10A to 10E.

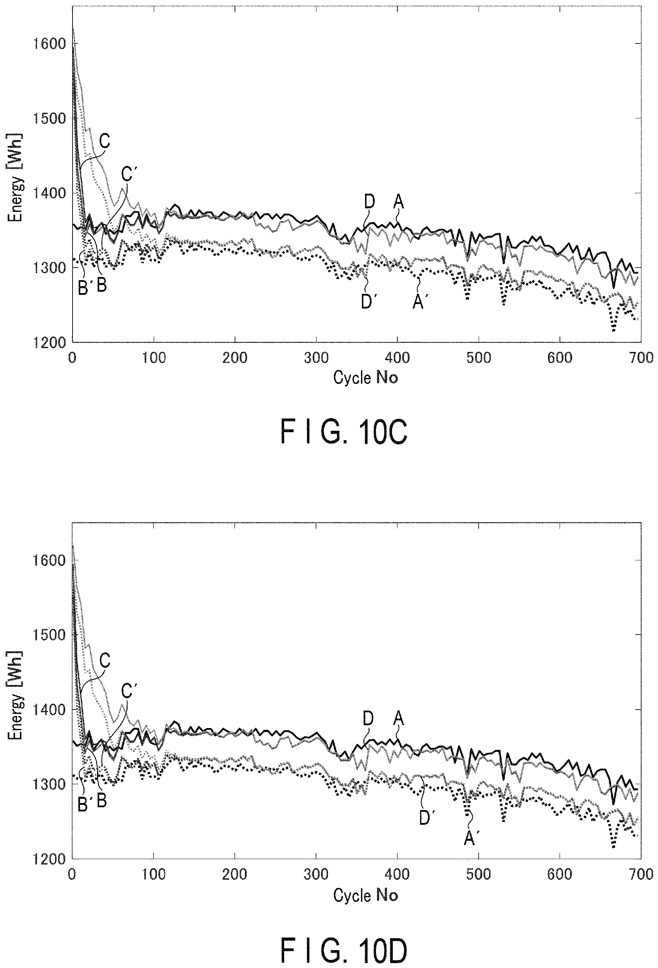

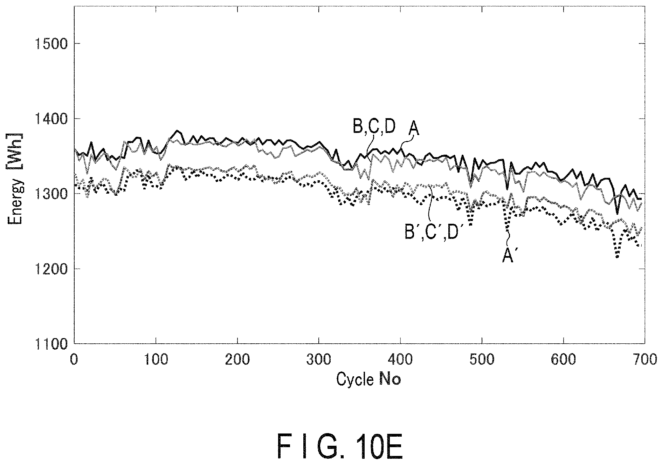

FIGS. 10A to 10E illustrate charge-discharge energy estimation values starting from any initial OCV value generated from the equation (6). FIG. 10A illustrates the charge-discharge energy estimation value when $K_{sep,1} = 0.8$ and $K_{sep,2} = 0.2$ are set as first adjustment coefficients. Similarly, FIG. 10B illustrates the charge-discharge energy estimation value when $K_{sep,1} = 0.8$ and $K_{sep,2} = 1.8$ are set as second adjustment coefficients, FIG. 10C illustrates the charge-discharge energy estimation value when $K_{sep,1} = 1.2$ and $K_{sep,2} = 0.2$ are set as third adjustment coefficients, FIG. 10D illustrates the charge-discharge energy estimation value when $K_{sep,1} = 1.2$ and $K_{sep,2} = 1.8$ are set as fourth adjustment coefficients, FIG. 10E illustrates the charge-discharge energy estimation value when $K_{sep,1} = K_{sep,2} = 1$ are set as fifth adjustment coefficients.

In each of FIGS. 10A to 10E, a line A (charge) and a dotted line A' (discharge) in the figures indicate actual transition of each cycle charge-discharge energy. Other lines B, C, and D (charge) and dotted lines B', C', and D' (discharge) in the figures are respectively estimated charge-discharge energies of cycles calculated as W^c,d in the following equation (7). Specifically, the line A indicates actual charge, the dotted line A' indicates actual discharge, the line B indicates charge with a high deformation rate (high learning rate L), and the dotted line B' indicates discharge with a high deformation rate. Further, the line C is charge at the middle deformation rate (learning rate L is medium), and the dotted line C' indicates medium rate discharge at the middle deformation rate. Furthermore, the line D indicates charge at a low deformation rate (learning rate L is low), and the dotted line D' indicates low rate discharge.

$$\widehat{W}_{c,d} = C_{fc} \int_0^1 \{\hat{V}_{oc}(S_{oc}) + \hat{I}_{c,d}(S_{oc}) \cdot \hat{Z}(S_{oc})\} dS_{oc} \qquad (7)$$

Here, $C_{fc}$ is a value of a full charge capacity corresponding to each cycle, W^c,d is an estimated value of estimated charge-discharge energy, V^oc(Soc) is the open-end voltage estimation function, Z^(Soc) is an impedance estimation function, and I^$_{c,d}$(Soc) is a charge-discharge current.

As can be easily understood from FIGS. 10A to 10E, it can be seen that transition of the charge-discharge energy estimation value is affected by $K_{sep,1}$ and is not affected by $K_{sep,2}$. Therefore, $K_{sep,1}$ is a determination element of a sign of an initial charge-discharge energy estimation error. For example, when $K_{sep,1}$ is smaller than 1 ($K_{sep,1} < 1$), an estimated value of an initial charge-discharge energy starts from a value smaller than an actually measured value. On the other hand, when $K_{sep,1}$ is larger than 1, the estimated value starts from a value larger than the actually measured value.

The number of cycles until the error converges is affected by the graph deformation rate illustrated in FIG. 7. Under conditions of "fast", "middle", and "slow" as these deformation rates, the numbers of cycles required for convergence were respectively about 20, 40, and 100. The transition of the estimated value after 100 cycles in all conditions was similar to a case of starting from a correct initial open circuit voltage OCV illustrated in FIG. 10E.

Thus, in the present embodiment, it is possible to estimate the charge-discharge energy for each cycle and calculate energy efficiency thereof. In the present embodiment, even if the estimation is arbitrary and unknown initial values of the open circuit voltage OCV and the internal impedance Z assuming the reused lithium ion battery, it can be performed similarly to an unused lithium ion battery.

This embodiment has the following two beneficial aspects.

First, there is a possibility of Kalman filter based differential analysis of the open circuit voltage OCV. Conventionally, the lithium ion battery is discharged at a low current, and a discharge capacity is differentiated by a discharge voltage or vice versa. Such a process is intended to reduce polarization if it is a low current discharge, and its time series data is approximated to the open circuit voltage OCV. This differential analysis is known to be effective for diagnosing an internal degradation state of the lithium ion battery, for example, transition of an operation window of a positive electrode and a negative electrode. On the other hand, since an operation different from an actual operation in which a discharge time is long and short-time processing is required is required, application to an actual reused rechargeable battery is not easy.

Second, in the present embodiment, since the open circuit voltage OCV profile can be continuously estimated during operation of the lithium ion battery accompanied with degradation, real-time differential analysis of the open circuit voltage OCV can be realized.

[Economic efficiency estimation apparatus]

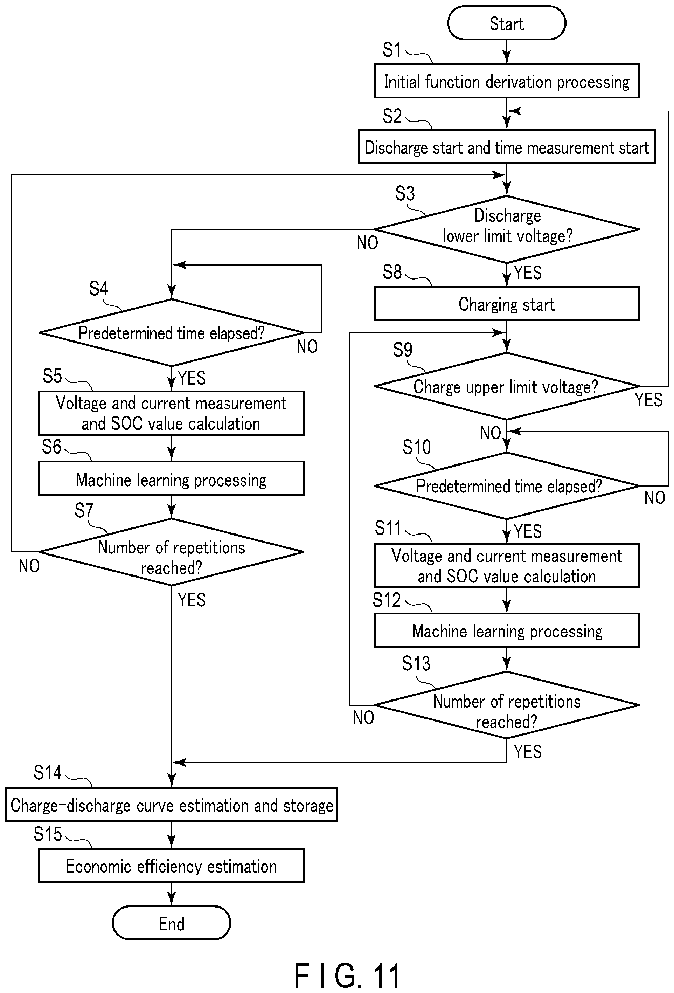

Next, the economic efficiency estimation apparatus using the charge-discharge curve of the rechargeable battery of the present embodiment will be described with reference to a flowchart illustrated in FIG. 11.

First, initial function derivation processing is performed (step S1). Specifically, an approximate curve based on an initial open circuit voltage function Voc(Soc) and an initial impedance function Z(Soc) to be corrected a first time is derived. For derivation of the approximate curve, a known method for approximating the charge-discharge curve can be used. For example, after a charge-discharge test is performed on the battery module 3 in advance, a charge-discharge voltage value and a current value in a charge-discharge cycle are measured. The approximate curve is obtained from the charge-discharge voltage value and the current value and stored. Then, the approximate curve of the initial open circuit voltage function Voc(Soc) and the initial impedance function Z(Soc) obtained from the following equation (8) of the charge-discharge curve, the open circuit voltage, and the impedance function

$$Vc,d(Soc)=Voc(Soc)+IZ(Soc) \qquad (8)$$

is set as a prior estimation function and used in the Kalman filter of the state estimation unit 30 to be described later.

Next, the discharge unit 23 electrically connects the secondary battery 11 to the discharging load unit 24 and starts discharging, and the time measurement unit 26 starts timing (step S2). In the present embodiment, the discharging is started first, but the charging may be started first. After the discharging is started, it is determined whether the voltage has reached a discharge lower limit voltage (step S3). If it is determined in step S3 that the discharge lower limit voltage has been reached (YES), the charging is started (step S8). On the other hand, when the voltage does not reach the discharge lower limit voltage (NO), the discharging is continued. For the discharging method, a constant current or a constant power can be selected. After the discharging is started, it is determined whether a prescribed time to be described later has elapsed (step S4). In the determination in step S4, the discharging is continued until the prescribed time elapses (NO), and if the prescribed time elapses (YES), the measurement unit 25 measures a discharge voltage $V_{meas}$ and a charge-discharge current I of the secondary battery 11, and the SOC calculation unit 28 calculates the SOC value (step S5). The SOC calculation unit 28 calculates the charging rate SOC using the Kalman filter of the state estimation unit 30 described above. At this time, correction is repeated to improve an accuracy of a posterior estimated approximate curve G. The approximate curve is corrected using positive and negative voltage values actually measured (with respect to the prior estimation values) at a plurality of the charging rates SOCs.

Next, after measurement of the discharge voltage and the discharge current and calculation of the SOC value are completed, machine learning processing is performed (step S6). In the machine learning processing, a prior estimation value is calculated using the prior estimation function and the actually measured value in accordance with a relational expression to be described later. Furthermore, the prior estimation value is corrected based on the estimation error and the Gaussian function to obtain a posterior estimation value, and the posterior estimated approximate curve is obtained based on the posterior estimation value. In such machine learning processing, the accuracy of the approximate curve can be improved by setting the obtained posterior estimated approximate curve as a new prior estimation function and repeating correction.

Next, it is determined whether the number of repeated corrections has reached a predetermined number of repetitions (step S7). In this determination, if the number of corrections has not reached the predetermined number of repetitions (NO), the process returns to step S3 to continue discharging. When the discharging is continued, it is determined again whether the voltage has reached the discharge lower limit voltage (step S3), and if the voltage has not reached the discharge lower limit voltage (NO), processing routine of steps S3 to S7 is repeated. If it is determined in step S7 that the number of corrections has reached the predetermined number of repetitions (YES), the charge-discharge curve is estimated in accordance with the relational expression with the voltage using the approximate curve of the open circuit voltage function and the impedance function (step S14). The estimated charge-discharge curve is temporarily stored in the server 16 of the energy management unit 5.

If it is determined in step S3 described above that the discharge lower limit voltage has been reached (YES), the charging is started (step S8). After the charging is started, it is determined whether the voltage has reached the charge upper limit voltage (step S9). If it is determined in step S9 that the charge upper limit voltage has not been reached (NO), it is determined whether a predetermined time has elapsed (step S10), and if it is determined that the charge upper limit voltage has been reached (YES), the process returns to step S2.

After a predetermined time has elapsed in the determination in step S10 (YES), the measurement unit 25 measures a discharge voltages Vc,d and the charge-discharge current I of the secondary battery 11, and the SOC calculation unit 28 calculates the charging rate SOC using the Kalman filter of the state estimation unit 30 described above (step S11). At this time, correction is repeated to improve an accuracy of a posterior estimated approximate curve G. The approximate curve is corrected using positive and negative voltage values actually measured (with respect to the prior estimation values) at a plurality of the charging rates SOCs. Furthermore, after measurement of the charge voltage and the charge current and calculation of the SOC value are completed in step S11, the machine learning processing to be described later is performed (step S12).

Subsequently, next, it is determined whether the number of repeated corrections has reached a predetermined number of repetitions (step S13). If it is determined in step S13 that the predetermined number of repetitions has not been reached (NO), the process returns to step S9 to continue charging. Here, when the charging is continued, it is determined in step S9 whether the charge upper limit voltage has been reached, and if the charge upper limit voltage has not been reached and the predetermined number of repetitions has not been reached in the determination of step S13, processing routine of steps S9 to S12 is repeated.

Here, the prescribed time for measuring the charge-discharge voltage in step S4 and step S10 described above will be described. The discharging is started by electrically connecting the battery module 3 to the discharging load unit 24 by the discharge unit 23. In the present embodiment, the actually measured value is measured every time a certain time elapses from the start of discharging. This certain time needs to be a period of time such that the charging rate SOC does not greatly change, and is approximately several tens of seconds (for example, 10 seconds to 80 seconds). Note that this range of the prescribed time is an example, and is variable when apparatus configuration or measurement characteristics are different, and is not strictly limited. Further, when voltage measurement is not started even if a time elapsed after the start of discharging exceeds the range of the prescribed time, the discharging is stopped and it is treated as a measurement error.

If it is determined in step S13 described above that the predetermined number of repetitions has been reached (YES), the process proceeds to step S14, and the charge-discharge curve is estimated in accordance with the relational expression with the voltage using the approximate curve of the open circuit voltage function and the impedance function.

The estimated charge-discharge curve is stored in the server 16 of the energy management unit 5. The stored charge-discharge curve is read from the server 16 in response to a request, and can be used for display on the display unit 15 and calculation of a charge-discharge power amount. Note that in the charge-discharge curve estimation processing, the charge-discharge processing, battery temperature stabilization, or the voltage and current measurements performed at the time of the charge-discharge processing may be performed on the single battery. Further, the single battery may be a single battery included in a plurality of the single batteries connected in parallel or in series in an assembled battery unit. Furthermore, the voltage and current measurements at the time of the charge-discharge processing or the battery temperature stabilization may be performed on various rechargeable batteries and an aggregate of a plurality of the rechargeable batteries.

Subsequently, economic efficiency estimation processing described later is performed (step S15), the full charge capacity FCC, a charge power amount Ec, and a discharge power amount Ed in a predetermined charge-discharge cycle, and an economic merit G for a charge-discharge cycle are estimated, and the economic efficiency index SOEc is estimated. After the estimated economic efficiency index SOEc is stored in the server 16 of the energy management unit 5, a series of routines ends. The stored economic efficiency index SOEc can be read from the server 16 and displayed on the display unit 15 according to a request.

[Machine learning processing]

Next, the machine learning processing of the present embodiment in steps S6 and S12 described above will be described.

First, these sample value profile data for the plurality of charging rates SOCs are expressed as vectors by the following equation (9).

$$D = (v_1, v_2, \cdots, v_{101})^{\mathsf{T}} \tag{9}$$

In the equation (9), D is a representative vector, and is applied to both the open circuit voltage OCV and the internal impedance Z. The number of elements of a vector D was 101, which corresponds to the $[0.01, 0.02, ..., 1]$ of the charging rate SOC. A deformation amount M in the graph illustrated in FIG. 4 is defined as the following equation (10) using a prior estimation value of an error E~ of a target physical quantity.

$$M_l = \tilde{E} L exp\left(-\frac{\left(10^{-2}(l-1) - S_{oc,0}\right)^2}{2\sigma^2}\right), \quad 1 \leq l \leq 101, \quad l \in \mathbb{Z} \tag{10}$$

A center coordinate of voltage deformation of the charging rate SOC on a horizontal axis of a profile graph illustrated in FIG. 4 is (Soc,0), that is, the charging rate SOC at a time when E~ is extracted from cycle data is (Soc,0). In the equation (10), L is a learning rate, and $0 < L \leq 1$. $\sigma$ is a value indicating a correction width (or standard deviation), that is, a rough correction range of graph deformation, and an excessively large value (deformation amount) is not desirable. 1 is an order of designating elements of the vector D. That is, the total deformation amount M can be expressed as the following equation (11).

$$M = (M_1, M_2, \cdots, M_{101})^{\mathsf{T}} \tag{11}$$

In summary, the graph deformation of the profile illustrated in FIG. 4 is expressed as the following equation (12).

$$\hat{D} = \hat{D}^- + M \tag{12}$$

In this equation (12), D^- is a prior estimation value of the vector D, and D^ is a posterior estimation value of the vector D. FIG. 4 illustrates an image of a graph deformation process. Furthermore, this was repeated during an entire charge-discharge cycle, that is, at various charging rates SOCs. E- is calculated by the Kalman filter described later. The prior estimation value (scalar) of the Kalman filter corresponds to the posterior estimation value of the Kalman filter estimated last time. The posterior estimation value estimated this time of the Kalman filter is used for graph deformation described later.

Next, an algorithm of the Kalman filter will be described.

The state estimation unit 30 of the present embodiment uses an adjusted extended Kalman filter for state estimation of the lithium ion battery. A state equation and an observation equation of the extended Kalman filter were formulated as a linear discrete-time system.

$$x_{k+1} = A_k x_k + B_k u_k + w_k \qquad (13)$$

$$y_k = C_k x_k + v_k \qquad (14)$$

$x_k$ in the equation (13) is a state space vector, and $y_k$ in the equation (14) is an observation value. Further, $w_k$ is system noise of normal distribution, that is, the average is 0 and the variance is $\sigma w^2$. $v_k$ is observation noise of the normal distribution, that is, the average is 0 and the variance is $\sigma v^2$. These equations are set based on an equivalent circuit model of the lithium ion battery illustrated in FIG. 5. In the equivalent circuit model, a resistive element ($R_0$), a parallel type first RC circuit ($R_1, C_1$), and a parallel type second RC circuit ($R_2, C_2$) are connected in series, and a power supply (Voc) is supplied. The first RC circuit and the second RC circuit are connected in series, which generates polarization voltages $V_{pol,1}$ and $V_{pol,2}$. The following equations (15), (16), and (17) can be established from this equivalent circuit model.

$$C_1 \frac{dV_{pol,1}}{dt} + \frac{V_{pol,1}}{R_1} = I_{c,d} \qquad (15)$$

$$C_2 \frac{dV_{pol,2}}{dt} + \frac{V_{pol,2}}{R_2} = I_{c,d} \qquad (16)$$

$$V_{c,d} = V_{oc} + V_{pol,1} + V_{pol,2} + I_{c,d} R_0 \qquad (17)$$

$R_0$, $R_1$, and $R_2$ in the equations (15), (16), and (17) are internal resistances, and $C_1$ and $C_2$ are capacitances. $V_{pol,1}$ and $V_{pol,2}$ are polarization voltages for each RC parallel circuit element. $V_{c,d}$ is a terminal voltage during charging and discharging. $I_{c,d}$ is a charge-discharge current, and is defined as a negative value during discharging. Voc is a voltage value of the open circuit voltage OCV. The equations (15), (16), and (17) can be converted into equations (18) and (19) using a forward Euler method.

$$V_{pol,1}(k+1) = \left(1 - \frac{\Delta t}{R_1 C_1}\right) V_{pol,1}(k) + \frac{I_{c,d}}{C_1} \Delta t \qquad (18)$$

$$V_{pol,2}(k+1) = \left(1 - \frac{\Delta t}{R_2 C_2}\right) V_{pol,2}(k) + \frac{I_{c,d}}{C_2} \Delta t \qquad (19)$$

In the equations (18) and (19), $\Delta t$ is time resolution between times k and k+1. Based on the equations (18) and (19), the state equation (13) and the observation equation (14) described above can be converted into equations (20) and (21).

$$x_{k+1} = \begin{bmatrix} S_{oc}(k+1) \\ V_{pol,1}(k+1) \\ V_{pol,2}(k+1) \\ R_0(k+1) \end{bmatrix} = \begin{bmatrix} 1 & 0 & 0 & 0 \\ 0 & 1 - \frac{\Delta t}{R_1 C_1} & 0 & 0 \\ 0 & 0 & 1 - \frac{\Delta t}{R_1 C_1} & 0 \\ 0 & 0 & 0 & 1 \end{bmatrix} \begin{bmatrix} S_{oc}(k) \\ V_{pol,1}(k) \\ V_{pol,2}(k) \\ R_0(k) \end{bmatrix} + \begin{bmatrix} \frac{\Delta t}{C_{fc}} \\ \frac{1}{C_1} \\ \frac{1}{C_2} \\ 0 \end{bmatrix} \cdot I_{c,d}(k) + bw_k \qquad (20)$$

$$y_k = V_{c,d}(k) = V_{oc}(k) + V_{pol,1}(k) + V_{pol,2}(k) + I_{c,d}(k) R_0(k) + v_k \qquad (21)$$

The equation (20) includes a linear function. On the other hand, since there is Voc(k) which is a function of a SOC parameter estimated by conventional pOCV or GITT, the equation (21) is a nonlinear function. In order to apply a nonlinear observation equation to the Kalman filter, the equation (21) is differentiated as the following equation (22).

$$y_k = V_{oc}(k) + \begin{bmatrix} \left.\dfrac{dV_{oc}}{dS_{oc}}\right|_{S_{oc}=\widehat{S_{oc}}^-(k)} \\ 1 \\ 1 \\ I_{c,d}(k) \end{bmatrix}^\mathsf{T} \cdot \begin{bmatrix} S_{oc}(k) \\ V_{pol,1}(k) \\ V_{pol,2}(k) \\ R_0(k) \end{bmatrix} + v_k \qquad (22)$$

That is, $A_k$, $B_k$, and $C_k$ in the equation (13) are set as in the following equation (23).

$$A_k = \begin{bmatrix} 1 & 0 & 0 & 0 \\ 0 & 1-\dfrac{\Delta t}{R_1 C_1} & 0 & 0 \\ 0 & 0 & 1-\dfrac{\Delta t}{R_1 C_1} & 0 \\ 0 & 0 & 0 & 1 \end{bmatrix}, \quad B_k = \begin{bmatrix} \dfrac{\Delta t}{C_{fc}} \\ \dfrac{1}{C_1} \\ \dfrac{1}{C_2} \\ 0 \end{bmatrix}, \quad C_k = \begin{bmatrix} \left.\dfrac{dV_{oc}}{dS_{oc}}\right|_{S_{oc}=\widehat{S_{oc}}^-(k)} \\ 1 \\ 1 \\ I_{c,d}(k) \end{bmatrix}^\mathsf{T} \qquad (23)$$

Under initial conditions, $R_1=R_2=10^{-4}$, $C_1=10^4$, and $C_2=10^5$ were set. Based on charge-discharge cycle conditions, $\Delta t$ was set to $\Delta t=10$. Differential of Ocv by Soc was calculated based on the OCV profile regressed to a sixth order polynomial described in the following subsection.

Two important steps of the Kalman filter were performed as follows: First, a state space vector $x^{\wedge-}_{k+1}$ and an error covariance matrix $P_{k+1}$ of a prior prediction were calculated as a prediction step using the following equations (24) and (25).

$$\widehat{x}^-_{k+1} = A_k\widehat{x}_k + B_k I_{c,d}(k) \qquad (24)$$

$$P_{k+1}{}^- = A_k P_k{}^- A_k{}^\mathsf{T} + \sigma_w{}^2 B_k B_k{}^\mathsf{T} \qquad (25)$$

Next, a Kalman gain $g_{k+1}$, and the state space vector $x^{\wedge-}_{k+1}$ and an error covariance matrix $P_{k+1}{}^-$ of a posterior estimation were calculated as filtering processing using the following equations (26), (27), and (28).

$$g_{k+1} = \frac{P_{k+1}{}^- C_{k+1}{}^\mathsf{T}}{C_{k+1} P_{k+1}{}^- C_{k+1}{}^\mathsf{T} + \sigma_v{}^2} \qquad (26)$$

$$\widehat{x}_{k+1} = \widehat{x}^-_{k+1} + g_{k+1}\left(y_{k+1} - \widehat{y}^-_{k+1}\right) \qquad (27)$$

$$P_{k+1} = (I - g_{k+1} C_{k+1})P_{k+1}{}^- \qquad (28)$$

First, $x^{\wedge}_0 = 0$ and $P_0 = 0$ were given as tentative vectors or matrices. Then, $A_k$, $B_k$, and $C_k$ based on cycle time series data and parameters of a previous step are substituted, and steps of the equations (24) to (28) are repeated. From these steps, values of the charging rate SOC, the open circuit voltage OCV, and the internal impedance Z are repeatedly estimated. At the same time, estimated profile graphs of the open circuit voltage OCV and the internal impedance Z are deformed by the Gaussian function addition.

Next, posterior estimation values of the open circuit voltage OCV and the internal impedance Z by the Kalman filter and extraction of a prior estimation error for graph deformation by the profile will be described.

From a process of the Kalman filter described above, the posterior estimation values of the open circuit voltage OCV and the internal impedance Z are calculated using the following equations (29) and (30). The internal impedance Z was assumed as a DC resistance and defined as a quotient of an overall polarization voltage $V_{pol,1(k)}+V_{pol,2(k)}+I_{c,d(k)}+V_{pol,1(k)}Z0(k)$ and the charge-discharge current.

$$\hat{V}_{oc}(k+1) = y_{k+1} - C_{k+1}\hat{x}_{k+1} \qquad (29)$$

$$\hat{Z}(k+1) = \frac{y_{k+1} - \hat{V}_{oc}(k+1)}{I_{c,d}(k+1)}, \quad (\hat{Z}(k+1) > 0) \qquad (30)$$

Prior estimation errors of V~oc(k) and Z~(k) corresponding to E~ in the equation (10) described above were calculated by differences between prior estimation values (V^oc⁻(k) and Z^⁻(k)) and estimated values (V^oc(k) and Z^(k)) of the Kalman filter. Approximation to the sixth order polynomial was applied to both the open circuit voltage OCV and the internal impedance Z, and a sample value corresponding to the vector D in the equation (9) was regressed as a polynomial for Soc. Therefore, V^oc⁻(k+1) and Z^⁻(k+1) were calculated as follows by the polynomial and S^oc (k+1) included in $x^{\wedge}_{k+1}$.

$$\hat{V}_{oc}{}^{-}(k+1) = \sum_{i=0}^{6} K_{ocv,i} \, \hat{S}_{oc}{}^{i}(k+1) \qquad (31)$$

$$\hat{Z}^{-}(k+1) = \sum_{i=0}^{6} K_{Z,i} \, \hat{S}_{oc}{}^{i}(k+1) \qquad (32)$$

Here, $K_{ocv,i}$ and $K_{Z,i}$ are regression coefficients of the polynomial.

The prior estimation errors V~oc(k+1)=V^oc(k+1)-V^oc⁻(k+1) and Z~(k+1)=Z^(k+1)-Z^⁻(k+1) are calculated and substituted as E~ in the equation (10), and at the same time, S^oc,0 is substituted into S^oc(k+1).

Next, the charge-discharge energy estimation will be described.

The sample values of the open circuit voltage OCV and the internal impedance Z corresponding to the vector D were continuously updated by estimation parameters by the Kalman filter and a profile graph deformation process.

$$\hat{W}_{c,d} = C_{fc} \int_{0}^{1} \left\{ \hat{V}_{oc}(S_{oc}) + \hat{I}_{c,d}(S_{oc}) \cdot \hat{Z}(S_{oc}) \right\} dS_{oc} \qquad (33)$$

Here, $C_{fc}$ is a value of the full charge capacity corresponding to each cycle. The charge-discharge energy per cycle is estimated using W^c,d: estimated value of estimated charge-discharge energy, V^(Soc): voltage estimation value, Z^(Soc): impedance estimation function, and I^c,d(Soc): charge-discharge current, and economic efficiency is estimated using the estimated charge-discharge energy and an electricity rate for each time zone.

As described above, $C_{fc}$ is set as an actually measured value in consideration of many reports of FCC degradation diagnosis. The constant power mode is employed as the charge-discharge cycle conditions, that is, a relationship between power P, I^c,d(Soc), V^oc(Soc), and Z^(Soc) is expressed by the following equation (34).

$$P = \hat{I}_{c,d}(S_{oc}) \cdot \left\{ \hat{V}_{oc}(S_{oc}) + \hat{I}_{c,d}(S_{oc}) \cdot \hat{Z}(S_{oc}) \right\} \qquad (34)$$

Here, it should be noted that P is defined as a negative value during discharging, similarly to $I_{c,d}$. Eventually, I^c,d (Soc) can be calculated by solving the quadratic equation (34) as follows.

$$\hat{I}_{c,d}(S_{oc}) = \frac{-\hat{V}_{oc}(S_{oc}) + \sqrt{\hat{V}_{oc}{}^{2}(S_{oc}) - 4P\hat{Z}(S_{oc})}}{2\hat{Z}(S_{oc})} \qquad (35)$$

According to this equation (35), W^c,d can be calculated from known P, V^oc(Soc), and Z^(Soc) in the equation (34).

In addition, since V^c(Soc) is used as a reference for the $C_k$ of the Kalman filter, the initial V^oc (Soc) has to be artificially set. The V^oc(Soc) profile of a commercially available lithium ion battery can typically be roughly set as three types of electrodes. That is, Co/Mn/Ni positive electrode type, $FePO_4$ positive electrode type, and Ti negative electrode type. The profile slightly differs depending on active material configuration by a manufacturer of the lithium ion battery, but a roughly set initial V^oc(Soc) can be converged by continuous learning by the Kalman filter and the profile graph deformation. That is, it is suggested that even if a somewhat uncertain numerical value is initially set, semi-supervised learning is performed to converge the value through continuous learning using the Kalman filter and the profile graph deformation to reach a correct answer. On the other hand, the initial Z^(Soc) is 0 by setting $x^{\wedge}_0 = 0$ in the Kalman filter. In addition, Z^(Soc) can also be converged similarly to V^c(Soc).

Next, analysis of the estimation error and estimation accuracy of the charge-discharge energy will be described.

In the present embodiment, the learning rate L, the correction width σ of the graph, and a difference between the initial V^oc(Soc) and the actual open circuit voltage OCV profile were mainly discussed. In order to perform analysis and quantitative comparison, an actually measured values Wc,d,i in an i-th cycle is measured, and the corresponding estimation error W-c,d,i is calculated from the estimated value W^c,d,i according to the following equation (36).

$$\widetilde{W}_{c,d,i} = W_{c,d,i} - \widehat{W}_{c,d,i} \qquad (36)$$

According to the present embodiment, it is possible to estimate a charge-discharge curve with high accuracy, and further, since the charge-discharge curve is estimated from an approximate curve of an open-end voltage value and impedance, it is possible to estimate a charge-discharge curve that is applicable even when a current rate changes. The estimated charge-discharge curve can be used for various purposes such as calculation of a charge-discharge energy E and evaluation of the economic efficiency of the rechargeable battery. The charge-discharge energy E can be calculated using the following equation (37). Here, FCC is the full charge capacity, V(Soc) is the charge-discharge voltage, and SOC is the charging rate.

$$E = FCC \int_0^1 V(SOC)\, dSOC \qquad (37)$$

[Economic efficiency estimation]

Next, the economic efficiency estimation processing of the present embodiment will be described.

Here, the estimated charge-discharge curve is used to estimate the economic efficiency. For example, when an electricity rate in a time zone with a high rate is Thigh [yen/kWh] and an electricity rate in a time zone with a low rate is Tlow [yen/kWh], an economic merit G [yen/kWh] in a charge-discharge cycle can be expressed by the following equation (38).

$$G = (T_{high} \times E_d - T_{low} \times E_c)/1000 \qquad (38)$$

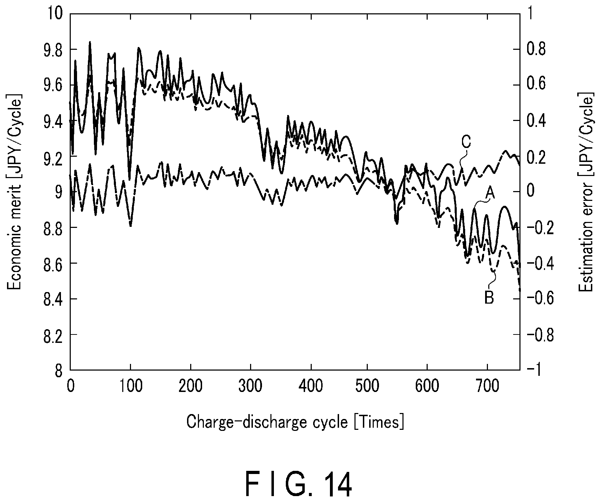

FIG. 14 illustrates an economic merit G [yen/kWh] obtained by estimating the charge power amount Ec and the discharge power amount Ed from a differential voltage Ve, in the charge-discharge test of the lithium ion battery 8-serial module of the present embodiment. Here, a line A is the economic merit G (estimated value), a line B is the economic merit G (actually measured value), and a line C is an estimation error. Note that a high value Thigh of the electricity rate was set at 25.33 yen/kWh and a low value Tlow was set at 17.46 yen/kWh, with reference to the Smart Life Plan (as of September 16, 2017) of TEPCO Energy Partner, Inc.

In general, the economic merit G (yen/kWh) of the rechargeable battery has a highest value when the rechargeable battery is a new one having a high value of the charge-discharge efficiency (Wh/Wh), and the economic merit G (yen/kWh) of the rechargeable battery has a lowest value at the time of the end of life of the rechargeable battery, at which the degradation of the rechargeable battery progresses and the full charge capacity FCC (Ah) and the charge-discharge efficiency (Wh/Wh) are low values. In the case of the lithium ion battery, it is common to define the end of life when the full charge capacity FCC (Ah) is reduced to 60% to 80% of that when the battery is new. Here, assuming that the time when an economic merit Gnew of a new rechargeable battery is obtained is 1 and the time when only an economic merit Gend of a rechargeable battery at the time of the end of life is obtained is 0, State of Economy (SOEc) that is an economic efficiency index of the rechargeable battery, which represents a state of a current economic merit Gcurr of the rechargeable battery, is defined by the following equation (39).

$$SOE_c = (G_{curr} - G_{end})/(G_{new} - G_{end}) \qquad (39)$$

where G is an economic merit for a charge-discharge cycle expressed by the equation (38), Gcurr is a current economic merit for a charge-discharge cycle, Gnew is an economic merit for a charge-discharge cycle at a time when the rechargeable battery is new, and Gend is an economic merit for a charge-discharge cycle at an end of battery life.

The differential voltage Ve can be measured while the stationary lithium ion battery is being operated. Therefore, if a relationship between the differential voltage Ve, and the full charge capacity FCC and charge-discharge voltages Vc(SOC) and Vd(SOC) is obtained in advance, a value of the economic efficiency index SOEc can be obtained from the relationship.

As described above, according to the present embodiment, the state estimation of the lithium ion battery by the Kalman filter can use the estimated charging rate Soc to determine (Soc,0), that is, the center coordinate of the graph deformation on an SOC axis. Even when an uncertain OCV profile generated by the equation (5) is initially set, accurate convergence of the OCV profile, and adaptive estimation to actual charge-discharge energy of each cycle as illustrated in FIGS. 10A to 10E described above can be realized.

The present embodiment is characterized in that the state estimation of the lithium ion battery is robust against an uncertain OCV reference function that is arbitrarily determined by the Kalman filter. That is, for the reused lithium ion battery having unknown characteristics, as long as information is known about any one of 1) ternary system, 2) iron phosphate system, and 3) titanic acid system, even if an initial OCV reference is somewhat uncertain, by provisionally setting the initial OCV reference from the known information and using the algorithm of the Kalman filter and the Gaussian function, it is possible to estimate the state parameters converged to appropriate values including the charging rate SOC value, the polarization voltage, and the internal impedance, and to converge learning of the efficiency degradation diagnosis. In the present embodiment, even if the estimation is arbitrary and unknown initial values of the open circuit voltage OCV and the internal impedance Z assuming the reused lithium ion battery, it can be performed similarly to the unused lithium ion battery. That is, the present invention can be applied to the reused lithium ion battery having unknown characteristics.

Therefore, the power storage apparatus of the present embodiment can estimate the SOC value, the polarization voltage, and the internal impedance of the lithium ion battery even if the power storage apparatus is unused or reused, by using the state estimation unit 30 employing the charge-discharge curve and the Kalman filter of the economic efficiency estimation apparatus 6, and a graph deformation method by the Gaussian function addition. Therefore, even when a plurality of the reused lithium ion batteries are used as an aggregate, they can be operated with high efficiency in consideration of the characteristics of individual reused lithium ion batteries.

According to the present embodiment, it is possible to estimate the charge-discharge curve with high accuracy, and further, since the charge-discharge curve is estimated from an approximate curve of an open-end voltage and impedance, it is possible to estimate the charge-discharge curve that is applicable even when the current rate changes. The estimated charge-discharge curve can be used for various purposes such as calculation of a charge-discharge energy E and evaluation of the economic efficiency of the rechargeable battery.

In addition, in the power storage apparatus of the present embodiment, if the economic efficiency index SOEc of the stationary lithium ion battery, which is installed as a distributed cooperative system, for example, an aggregate of the plurality of lithium ion batteries including a recycled lithium ion battery, can be obtained in real time, it is possible to determine a charge priority of preferentially selecting and operating a more profitable stationary lithium ion battery from among the stationary lithium ion batteries (dispersed battery) that are cooperatively controlled, and to perform economical operation.

Note that the present invention is not limited to the above embodiments, and various modifications may be made without departing from the spirit of the invention. Furthermore, various inventions for solving the above problems are extracted by selecting or combining a plurality of disclosed constituent elements.

**Claims**

1. An economic efficiency estimation apparatus using a charge-discharge curve, comprising:

   a function derivation unit configured to derive an approximate curve of an open-end voltage function and an impedance function to be corrected a first time, and set the approximate curve as a prior estimation function;
   a charge unit configured to detect a charge state of a secondary battery and charge the secondary battery within a range up to a predetermined charge upper limit voltage;
   a discharge unit configured to electrically connect a load to the secondary battery and cause the secondary battery to discharge power;
   a measurement unit configured to measure a charge-discharge voltage and a charge-discharge current in a cycle of a predetermined time from a start of charging or discharging by the charge unit or the discharge unit;
   a state estimation unit configured to estimate state parameters including a value of a charging rate, and a polarization voltage and an internal impedance of the secondary battery using an algorithm of a Kalman filter; and
   an estimation arithmetic processing unit configured to obtain an estimation error of an open-end voltage value and an impedance value from the prior estimation function, the state parameters, and a relational expression of the charge-discharge voltage and the charge-discharge current measured by the measurement unit, calculate a posterior estimation value by correcting the open-end voltage value and the impedance value in accordance with a correction expression using a Gaussian function having a predetermined learning rate L and a correction width $\sigma$ as terms, correct the prior estimation function based on the posterior estimation value, set a new prior estimation function, estimate the charge-discharge curve, wherein
an economic efficiency index is estimated based on a charge-discharge power amount of the secondary battery estimated from the charge-discharge curve.

2. The economic efficiency estimation apparatus according to claim 1, wherein the open-end voltage function and the impedance function are differentiable and integrable functions.

3. The economic efficiency estimation apparatus according to claim 1, wherein in the Kalman filter, an observation equation includes a derivative of the open-end voltage function, and the open-end voltage function before the derivative includes an error.

4. The economic efficiency estimation apparatus according to claim 1, wherein the learning rate L is adjusted to be 0.1 or less, and the learning rate L and the correction width $\sigma$ are adopted such that a relationship between the learning rate L and the correction width $\sigma$ satisfies the following equations.

$$L \leqq -10^{(-12.5\sigma-1.375)}, \quad 0 < \sigma \leqq 0.11$$

5. The economic efficiency estimation apparatus according to any one of claims 1 to 3, wherein the correction expression using the Gaussian function is the following equations

$$\boldsymbol{M} = (M_1, M_2, \cdots, M_{101})^\mathsf{T}$$

$$M_l = \bar{E}Lexp\left(-\frac{\left(10^{-2}(l-1)-S_{oc,0}\right)^2}{2\sigma^2}\right), \quad 1 \leq l \leq 101, \quad l \in \mathbb{Z}$$

where, M is a deformation amount vector, 1 is an order of designating elements of the vector M, L is the learning rate, E~ is an error of a target physical quantity, Soc is the charging rate, and (Soc,0) is a center coordinate on a charging rate axis of the Gaussian function.

6. The economic efficiency estimation apparatus according to claim 1, wherein charge-discharge energy per cycle is estimated using the open-end voltage function and the impedance function according to the following equation

$$\widehat{W}_{c,d} = C_{fc} \int_0^1 \left\{ \hat{V}_{oc}(S_{oc}) + \hat{I}_{c,d}(S_{oc}) \cdot \hat{Z}(S_{oc}) \right\} dS_{oc}$$

where, $C_{fc}$ is a value of a full charge capacity corresponding to each cycle, W^c,d is an estimated value of estimated charge-discharge energy, V^oc(Soc) is an open-end voltage estimation function, Z^(Soc) is an impedance estimation function, and I^c,d(Soc) is the charge-discharge current.

7. The economic efficiency estimation apparatus according to claim 6, wherein economic efficiency is estimated using the charge-discharge energy and an electricity rate for each time zone.

8. The economic efficiency estimation apparatus according to claim 7, wherein a charge priority of a distributed rechargeable battery related to a countermeasure for surplus power of variable renewable energy is determined based on the economic efficiency estimated.

9. An economic efficiency estimation method comprising:

deriving an approximate curve of an open-end voltage function and impedance function to be corrected a first time, and setting the approximate curve as a prior estimation function;

detecting a charge state of a secondary battery and charging the secondary battery within a range up to a predetermined charge upper limit voltage;

discharging power from the secondary battery by a load connected to the secondary battery;

measuring a charge-discharge voltage and a charge-discharge current in a cycle of a predetermined time from a start of charging or discharging;

estimating state parameters including a value of a charging rate, and a polarization voltage and an internal impedance of the secondary battery using an algorithm of a Kalman filter;

obtaining an estimation error of an open-end voltage value and an impedance value from the prior estimation function, the state parameters, and a relational expression of the charge-discharge voltage and the charge-discharge current measured by the measurement unit, calculating a posterior estimation value by correcting the open-end voltage value and the impedance value in accordance with a correction expression using a Gaussian function having a predetermined learning rate L and a correction width $\sigma$ as terms, correcting the prior estimation function based on the posterior estimation value, setting a new prior estimation function, and estimating a charge-discharge curve; and

estimating charge-discharge energy per cycle using the open-end voltage estimation function and the impedance estimation function according to the following equation, and estimating economic efficiency using the charge-discharge energy and an electricity rate for each time zone

$$\widehat{W}_{c,d} = C_{fc} \int_0^1 \left\{ \widehat{V}_{oc}(S_{oc}) + \hat{I}_{c,d}(S_{oc}) \cdot \hat{R}(S_{oc}) \right\} dS_{oc}$$

where, $C_{fc}$ is a value of a full charge capacity corresponding to each cycle, $\widehat{W}_{c,d}$ is an estimated value of estimated charge-discharge energy, $\widehat{V}_{oc}(Soc)$ is an open-end voltage estimation function, $\widehat{Z}(Soc)$ is an impedance estimation function, and $\hat{I}_{c,d}(Soc)$ is the charge-discharge current.

10. The economic efficiency estimation apparatus according to claim 1, wherein the economic efficiency index is obtained by dividing a difference between a current economic merit and an economic merit at an end of battery life by a difference between an economic merit at a time when the battery is new and an economic merit at the end of battery life, in a charge-discharge cycle.

F I G. 1

Energy management unit 5

Charge-discharge curve and economic
efficiency estimation apparatus

6

27 26 30

Estimation arithmetic processing unit

Time
measurement
unit

22 24 23 25

DV
DI

Function
derivation
unit

~29

State
estimation
unit

Charging power
supply unit

Discharging
load unit

Discharge
unit

Measurement
unit

SOC
calculation
unit

28

Battery module ~ 3

Battery temperature
measurement unit

~ 7

F I G. 2

| Sample detail | 8 series of LIB modules<br>(NiMnCo cathode, C anode) |
|---|---|
| Specification | 29.6 V, 50 Ah, 1.48 kWh |
| Input-output power | 1085 W (Constant power) |
| Range of charge state | 0 to 1 (Based on manufacturer specification) |
| Range of module voltage | 21.6 V ∼ 33.2 V |
| Charge-discharge cycle | 700 cycles |
| Measurement time interval | 10 seconds |
| Ambient temperature of cycle test | Room temperature |

# F I G. 3

# F I G. 4

FIG. 5

FIG. 6

| Group | $L$ | $\sigma$ |
|---|---|---|
| High rate | $10^{-3.1} \leq L \leq 10^{-1.5}$ | $0.01 \leq \sigma \leq 0.02$ |
| Medium rate | $10^{-3.7} \leq L \leq 10^{-3.2}$ | $0.11 \leq \sigma \leq 0.27$ |
| Low rate | $10^{-5} \leq L \leq 10^{-3.8}$ | $0.91 \leq \sigma \leq 0.99$ |

F I G. 7

F I G. 8A

F I G. 8B

F I G. 9A

F I G. 9B

F I G. 9C

F I G. 10A

F I G. 10B

F I G. 10C

F I G. 10D

F I G. 10E

F I G. 11

F I G. 12

F I G. 13

F I G. 14

<table>
<tr><td colspan="2" align="center"><b>INTERNATIONAL SEARCH REPORT</b></td><td>International application No.<br><br><b>PCT/JP2023/023864</b></td></tr>
</table>

**A.    CLASSIFICATION OF SUBJECT MATTER**

*G01R 31/367*(2019.01)i; *G01R 31/378*(2019.01)i; *G01R 31/382*(2019.01)i; *G01R 31/385*(2019.01)i; *G01R 31/387*(2019.01)i; *G01R 31/389*(2019.01)i; *G01R 31/392*(2019.01)i; *H01M 10/44*(2006.01)i; *H01M 10/48*(2006.01)i; *H02J 7/00*(2006.01)i
FI:    G01R31/367; G01R31/382; G01R31/385; G01R31/387; G01R31/389; G01R31/392; H02J7/00 Y; H01M10/48 P; H01M10/44 P; G01R31/378

According to International Patent Classification (IPC) or to both national classification and IPC

**B.    FIELDS SEARCHED**

Minimum documentation searched (classification system followed by classification symbols)

G01R31/36; H01M10/44; H01M10/48; H02J7/00; B60L3/00

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

**C.    DOCUMENTS CONSIDERED TO BE RELEVANT**

| Category* | Citation of document, with indication, where appropriate, of the relevant passages | Relevant to claim No. |
|---|---|---|
| A | WO 2019/240270 A1 (DAIWA CAN COMPANY) 19 December 2019 (2019-12-19)<br>entire text, all drawings | 1-10 |
| A | WO 2019/117198 A1 (DAIWA CAN COMPANY) 20 June 2019 (2019-06-20)<br>entire text, all drawings | 1-10 |
| A | JP 2022-7946 A (DENSO CORPORATION) 13 January 2022 (2022-01-13)<br>entire text, all drawings | 1-10 |
| A | JP 2017-220293 A (DAIWA CAN COMPANY) 14 December 2017 (2017-12-14)<br>entire text, all drawings | 1-10 |
| A | JP 2015-224876 A (DENSO CORPORATION) 14 December 2015 (2015-12-14)<br>entire text, all drawings | 1-10 |
| A | CN 111896881 A (SHANGHAI 6TH PEOPLE'S HOSPITAL) 06 November 2020<br>(2020-11-06)<br>entire text, all drawings | 1-10 |

☐ Further documents are listed in the continuation of Box C.        ☑ See patent family annex.

\*    Special categories of cited documents:
"A"    document defining the general state of the art which is not considered to be of particular relevance
"E"    earlier application or patent but published on or after the international filing date
"L"    document which may throw doubts on priority claim(s) or which is cited to establish the publication date of another citation or other special reason (as specified)
"O"    document referring to an oral disclosure, use, exhibition or other means
"P"    document published prior to the international filing date but later than the priority date claimed

"T"    later document published after the international filing date or priority date and not in conflict with the application but cited to understand the principle or theory underlying the invention
"X"    document of particular relevance; the claimed invention cannot be considered novel or cannot be considered to involve an inventive step when the document is taken alone
"Y"    document of particular relevance; the claimed invention cannot be considered to involve an inventive step when the document is combined with one or more other such documents, such combination being obvious to a person skilled in the art
"&"    document member of the same patent family

| Date of the actual completion of the international search | Date of mailing of the international search report |
|---|---|
| **16 August 2023** | **29 August 2023** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

**INTERNATIONAL SEARCH REPORT**
**Information on patent family members**

| International application No. |
| --- |
| **PCT/JP2023/023864** |

| Patent document cited in search report | | | Publication date (day/month/year) | Patent family member(s) | | | Publication date (day/month/year) |
| --- | --- | --- | --- | --- | --- | --- | --- |
| WO | 2019/240270 | A1 | 19 December 2019 | US<br>entire text, all drawings<br>CN | 2021/0096189<br><br>112368588 | A1<br><br>A | |
| WO | 2019/117198 | A1 | 20 June 2019 | US<br>entire text, all drawings<br>CN | 2020/0309860<br><br>111512171 | A1<br><br>A | |
| JP | 2022-7946 | A | 13 January 2022 | US<br>entire text, all drawings<br>DE | 2021/0270907<br><br>102021104868 | A1<br><br>A1 | |
| JP | 2017-220293 | A | 14 December 2017 | (Family: none) | | | |
| JP | 2015-224876 | A | 14 December 2015 | (Family: none) | | | |
| CN | 111896881 | A | 06 November 2020 | (Family: none) | | | |

Form PCT/ISA/210 (patent family annex) (January 2015)